(19) Europäisches Patentamt
European Patent Office
Office européen des brevets

(11) **EP 4 379 801 B1**

(12) **FASCICULE DE BREVET EUROPEEN**

(45) Date de publication et mention
de la délivrance du brevet:
**18.06.2025 Bulletin 2025/25**

(21) Numéro de dépôt: **23209476.3**

(22) Date de dépôt: **13.11.2023**

(51) Classification Internationale des Brevets (IPC):
*H10D 30/01* (2025.01)   *H10D 84/01* (2025.01)
*H10D 84/82* (2025.01)   *H10D 30/47* (2025.01)
*H10D 62/85* (2025.01)   *H10D 64/23* (2025.01)
*H10D 84/05* (2025.01)

(52) Classification Coopérative des Brevets (CPC):
**H10D 30/015; H10D 84/01; H10D 84/82;**
H10D 30/475; H10D 62/8503; H10D 62/854;
H10D 64/254; H10D 84/05

(54) **DISPOSITIF MICROÉLECTRONIQUE À TENUE EN TENSION VERTICALE AMÉLIORÉE**

MIKROELEKTRONISCHE VORRICHTUNG MIT VERBESSERTER VERTIKALER SPANNUNGSFESTIGKEIT

MICROELECTRONIC DEVICE WITH IMPROVED VERTICAL VOLTAGE WITHSTAND

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.11.2022 FR 2212586**

(43) Date de publication de la demande:
**05.06.2024 Bulletin 2024/23**

(73) Titulaire: **Commissariat à l'Energie Atomique et aux Energies Alternatives 75015 Paris (FR)**

(72) Inventeurs:
• **GARNIER, Gennie**
  **38054 GRENOBLE cedex 09 (FR)**
• **GWOZIECKI, Romain**
  **38054 GRENOBLE cedex 09 (FR)**
• **GILLOT, Charlotte**
  **38054 GRENOBLE cedex 09 (FR)**

(74) Mandataire: **Hautier IP 20, rue de la Liberté 06000 Nice (FR)**

(56) Documents cités:
**US-A1- 2013 146 946**

• **LI XIANGDONG ET AL: "Monolithically integrated GaN power ICs - News", COMPOUND SEMICONDUCTOR, 1 April 2020 (2020-04-01), XP093055474, Retrieved from the Internet <URL:https://compoundsemiconductor.net/article/111292/Monolithically_integrated_GaN_power_ICs> [retrieved on 20230619]**

**EP 4 379 801 B1**

**Description**

**DOMAINE TECHNIQUE**

La présente invention concerne le domaine des dispositifs microélectroniques, notamment les composants à base de GaN épitaxié sur silicium. Elle trouve par exemple pour application particulièrement avantageuse le domaine de l'électronique de puissance.

**ETAT DE LA TECHNIQUE**

Les transistors, par exemple les transistors composés de GaN épitaxié sur du silicium (couramment désignés transistors « GaN-sur-Si »), présentent en général trois contacts : une source, une grille et un drain. Dans le cadre spécifique de l'intégration de plusieurs composants latéraux épitaxiés sur un substrat hétérogène, tels que plusieurs transistors GaN-sur-Si, il est notoirement connu, compte tenu de l'architecture et des propriétés des différentes couches constituant les composants, qu'il est nécessaire que le potentiel du substrat de chacun des composants soit équivalent à celui de sa source. Cela permet en effet de limiter les phénomènes dits de « current collapse » (en français « chute de courant »), qui se traduisent par une augmentation importante de la résistance à l'état passant du composant après un blocage à forte tension. Il apparaît ainsi que l'intégration de plusieurs composants ne peut pas être réalisée sur un même substrat, dont le potentiel serait commun à tous les composants. Cela est notamment le cas pour les dispositifs type « bras de pont », intégrant deux composants en série.
Il existe différentes solutions permettant la fabrication de dispositifs intégrant plusieurs composants.
Les approches visant à remplacer le substrat de silicium par un isolant électrique épais (par exemple de plusieurs microns), même très bon conducteur thermique, ont également pour impact de réduire l'influence de la polarisation du substrat sur la répartition du potentiel au sein du dispositif, ce qui peut être équivalent au fait d'avoir un potentiel de substrat flottant. Cet effet est bien documenté dans le cadre des dispositifs de type SOI avec oxyde enterré épais (voir notamment : Q. Xie, C. Lee, J. Xu, C. Wann, J. Y. -. Sun et Y. Taur, "Comprehensive Analysis of Short-Channel Effects in Ultrathin SOI MOSFETs," in IEEE Transactions on Electron Devices, vol. 60, no. 6, pp. 1814-1819, June 2013). Cela a pour conséquence d'empirer les phénomènes de « current collapse ».
Le document GaN Integrated Bridge Circuits on Bulk Silicon Substrate: Issues and Proposed Solution, Jin Wei, Meng Zhang, Gang Lyu et Kevin Chen propose une approche permettant par exemple d'isoler les composants entre eux et d'assurer une polarisation indépendante de chacun, mais au prix de l'ajout de couches de silicium supplémentaires pouvant impacter négativement la résistance thermique et ajoutant potentiellement des capacités parasites supplémentaires. La tenue en tension verticale est en revanche toujours assurée par les couches GaN épitaxiées.
D'autres approches (voir là encore *GaN Integrated Bridge Circuits on Bulk Silicon Substrate: Issues and Proposed Solution*, Jin Wei, Meng Zhang, Gang Lyu et Kevin Chen) visent à utiliser un potentiel médian ou variable, mais cette polarisation non-idéale se traduit par exemple par des problèmes de type « current collapse ».
Une autre solution consiste à former un empilement des différentes couches qui constitueront les composants unitaires, et former dans cet empilement des tranchées permettant d'individualiser les composants. Les différents composants peuvent tous s'étendre depuis un socle commun laissé intact lors de la formation des tranchées.
Chacun des composants unitaires présente alors typiquement la structure suivante :

- un substrat,
- des couches tampon, couramment désignées couches buffers, permettant d'ajuster les contraintes entre les différences de maille du matériau constituant le substrat et du matériau à la base des couches actives,
- les couches actives du composant.

Dans le cadre spécifique d'un composant GaN-sur-Si, le substrat est conducteur. Ainsi, la tenue en tension entre celui-ci et le contact de drain (qui sera polarisé à la tension haute, typiquement 100V, 200V, 650V, 1200V ou plus, selon la classe de composant) est conditionnée par les propriétés isolantes des couches buffers. Ces couches buffers doivent notamment présenter les caractéristiques suivantes :

- La capacité à tenir la tension maximum qui sera appliquée sur le composant, que ce soit pour des temps brefs ou des durées très longues.
- La capacité à présenter un faible courant de fuite, c'est-à-dire à se comporter au maximum comme un isolant diélectrique.

Un autre aspect important est que les couches buffers sont en général reliées au radiateur lié au boitier du dispositif, afin d'évacuer la chaleur générée lors du fonctionnement du composant, notamment les pertes résistives et les pertes en commutation. Ainsi, il est souhaitable que ces couches buffers présentent une conductivité thermique élevée. Cela permet d'évacuer plus facilement la chaleur contenue dans le dispositif et de limiter l'échauffement menant à la dégradation des performances du composant et plus généralement sa dégradation globale.

Cependant, les couches buffers permettant l'ajustement des contraintes entre le substrat et les couches actives des composants ne présentent pas toujours les propriétés permettant à la fois une bonne tenue en tension des composants et une bonne évacuation thermique.

L'article *Monolithically Integrated GaN Power ICs - The demonstration of half-bridges and single-stage buck converters takes GaN power ICs another step forward* de Xiangdong Li et Stefaan Decoutere présente les résultats obtenus pour un dispositif du type venant d'être décrit. La solution présentée dans cet article permet théoriquement d'isoler entre eux les composants et de polariser indépendamment chacune des faces arrière des composants, en incluant une couche isolante entre un substrat support de silicium et une couche de silicium de nucléation de l'épitaxie des couches actives, en isolant latéralement les composants entre eux grâce à des tranchées. La couche de nucléation est également connectée à la source grâce à un contact traversant. En revanche, cette solution ne fonctionne pas pour des dispositifs devant supporter des tensions élevées (i.e. supérieures à 200V), car les épaisseurs d'épitaxie de couches GaN sur un substrat SOI nécessaires pour la tenue en tension verticale induisent des contraintes mécaniques trop élevées.

Le document US 2013/146946 A1 présente une structure intégrant plusieurs composants latéraux. Cependant ce document ne résout pas les problèmes de tenue en tension des composants.

Un objectif de la présente invention est ainsi de proposer un dispositif microélectronique intégrant plusieurs composants unitaires et présentant à la fois une bonne tenue en tension et une bonne évacuation thermique.

## RESUME

Pour atteindre cet objectif, selon la revendication 1 on prévoit un dispositif microélectronique comprenant :

- un premier transistor à effet de champ comprenant une première couche active ainsi qu'un premier drain, une première source, une première grille surmontant la première couche active,
- un deuxième transistor à effet de champ comprenant une deuxième couche active ainsi qu'un deuxième drain, une deuxième source et une deuxième grille surmontant la deuxième couche active, la deuxième source étant reliée électriquement au premier drain,
- une première électrode arrière, sous-jacente à la première couche active selon une direction d'empilement perpendiculaire à un plan transversal défini par une première direction et une deuxième direction, la première électrode arrière étant reliée électriquement à la première source,
- une deuxième électrode arrière , sous-jacente à la deuxième couche active selon la direction d'empilement, la deuxième électrode arrière étant séparée de la première électrode arrière, la deuxième électrode arrière étant reliée électriquement à la deuxième source,
- un empilement.

L'empilement comprend notamment :

- une troisième couche active continue et à base de GaN, sous-jacente à la première couche active d'une part et à la deuxième couche active d'autre part, et
- une couche isolante s'étendant, selon la direction d'empilement, entre la première électrode arrière et la première couche active d'une part et la deuxième électrode arrière et la deuxième couche active d'autre part, la couche isolante étant continue et à base d'un premier diélectrique, la couche isolante présentant selon la direction d'empilement un champ critique $E_c$, la couche isolante présentant selon la direction d'empilement une épaisseur dite épaisseur de diélectrique e1500 comprise entre $2*e_{1500,min}$ et $10*e_{1500,min}$, avec $e_{1500,min}=V_{cible}/E_c$, $V_{cible}$ étant une tension de claquage cible de la couche isolante, le premier diélectrique présentant une conductivité thermique $\lambda 1$ supérieure à 1 $W.m^{-1}.K^{-1}$.

La couche assurant la tenue en tension verticale dans le dispositif est ici la couche isolante. Son épaisseur est dimensionnée de façon à optimiser cette tenue. Elle permet notamment de garantir que le dispositif résiste à l'application de toute tension inférieure à la tension de claquage cible $V_{cible}$. Cette tension de claquage cible $V_{cible}$ de la couche isolante est indiquée dans la fiche de spécification.

Le niveau de conductivité thermique du premier diélectrique permet en outre de garantir une bonne évacuation de la chaleur contenue dans le dispositif.

L'invention tire donc profit des propriétés électriques et thermiques des diélectriques.

## BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

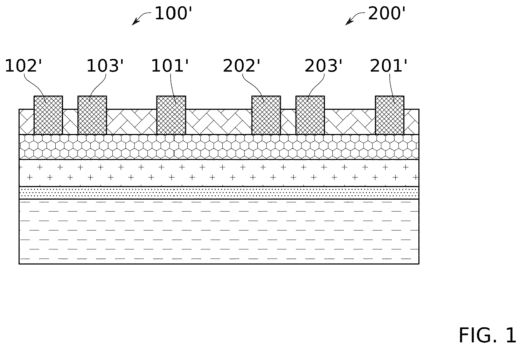

La figure 1 représente un dispositif selon l'art antérieur intégrant deux composants unitaires.
La figure 2A représente une vue en coupe d'un mode de réalisation du dispositif selon l'invention.
La figure 2B représente une vue en coupe d'un mode de réalisation du dispositif selon l'invention dans lequel la connexion électrique entre la source et l'électrode arrière de chacun des transistors est assurée par des éléments de connexion électrique traversant l'empilement du dispositif.
La figure 2C représente une vue de dessus d'un mode de réalisation du dispositif selon l'invention.
La figure 2D représente une vue en coupe d'un mode de réalisation du dispositif selon l'invention.
La figure 3A illustre la bonne tenue en tension verticale du dispositif et le faible couplage latéral entre les deux transistors du composant lorsque les différentes couches du dispositif sont correctement dimensionnées.
La figure 3B illustre la mauvaise tenue en tension verticale du dispositif et l'important couplage latéral entre les deux transistors du composant lorsque l'épaisseur de la couche isolante du dispositif est trop importante.
Les figures 4A à 4E représentent un premier mode de réalisation d'un procédé de fabrication du dispositif selon l'invention.
Les figures 5A à 5M représentent un deuxième mode de réalisation d'un procédé de fabrication du dispositif selon l'invention.
La figure 6 illustre un dispositif selon un mode de réalisation de l'invention, comprenant notamment une couche d'ajustement des contraintes ou couche buffer.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple avantageux, $V_{cible} \geq 900V$.

Selon un mode de réalisation, dans le plan transversal, la première électrode arrière et la deuxième électrode arrière sont séparées d'une distance d'isolation latérale $d_{iso}$ supérieure à 50 $\mu$m, de préférence supérieure à 100 $\mu$m.

Selon un mode de réalisation avantageux, en projection dans le plan transversal et selon toute direction du plan transversal :

- la première électrode arrière est en saillie par rapport à la première couche active sur une première distance de débordement $d_{deb,1}$, avec $d_{deb,1}>0$, et
- la deuxième électrode arrière est en saillie par rapport à la deuxième couche active sur une deuxième distance de débordement $d_{deb,2}$, avec $d_{deb,2}>0$.

Selon un exemple, selon la direction d'empilement, la troisième couche active présente une épaisseur dite épaisseur active $e_{1100}$, et $d_{deb,1} \geq e_{1100}+e_{1500}$ et $d_{deb,2} \geq e_{1100}+e_{1500}$.

Selon un exemple avantageux, l'empilement présente une épaisseur $e_{1000}$ selon la direction d'empilement, avec $d_{deb,1} \geq e_{1000}$ et $d_{deb,2} \geq e_{1000}$.

Selon un mode de réalisation, le premier diélectrique est l'un parmi l'AIN, le $SiO_2$, l'$Al_2O_3$, le $Si_3N_4$, le $HfO_2$ et le diamant.

Selon un mode de réalisation, le dispositif comprend en outre un premier élément de connexion électrique traversant l'empilement et connectant électriquement la première source à la première électrode arrière.

Selon un mode de réalisation, le dispositif comprend en outre un deuxième élément de connexion électrique traversant l'empilement et connectant électriquement la deuxième source à la deuxième électrode arrière.

Selon un exemple, $e_{1500} \geq 1\mu$m, de préférence $e_{1500} \geq 2\mu$m.

Selon un mode de réalisation, la troisième couche active est directement au contact de la première couche active et de la deuxième couche active.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants. De même, une couche à base de GaN comprend typiquement du GaN et des alliages d'AlGaN ou d'InGaN.

Le terme « matériau III-V » fait référence à un semi-conducteur composé d'un ou plusieurs éléments de la colonne III et de la colonne V du tableau périodique de Mendeleïev. On compte parmi les éléments de la colonne III le bore, le gallium, l'aluminium ou encore l'indium. La colonne V contient par exemple l'azote, l'arsenic, l'antimoine et le phosphore.

Le champ électrique critique d'un milieu isolant, également appelé rigidité diélectrique, représente la valeur maximum que le milieu en question peut supporter avant le déclenchement d'un arc électrique (claquage de l'isolant). Cette caractéristique s'exprime en V/m, ou plus couramment en kV/mm ou MV/m. Pour un milieu isolant auquel on applique, au niveau de deux électrodes, une tension V, le champ électrique critique s'exprime de la façon suivante :

[Math 1]

$$E_c = \frac{V_c}{d}$$

avec $V_c$ la tension de claquage, i.e. la tension à laquelle un court-circuit se produit entre les électrodes, et d la distance entre les électrodes.

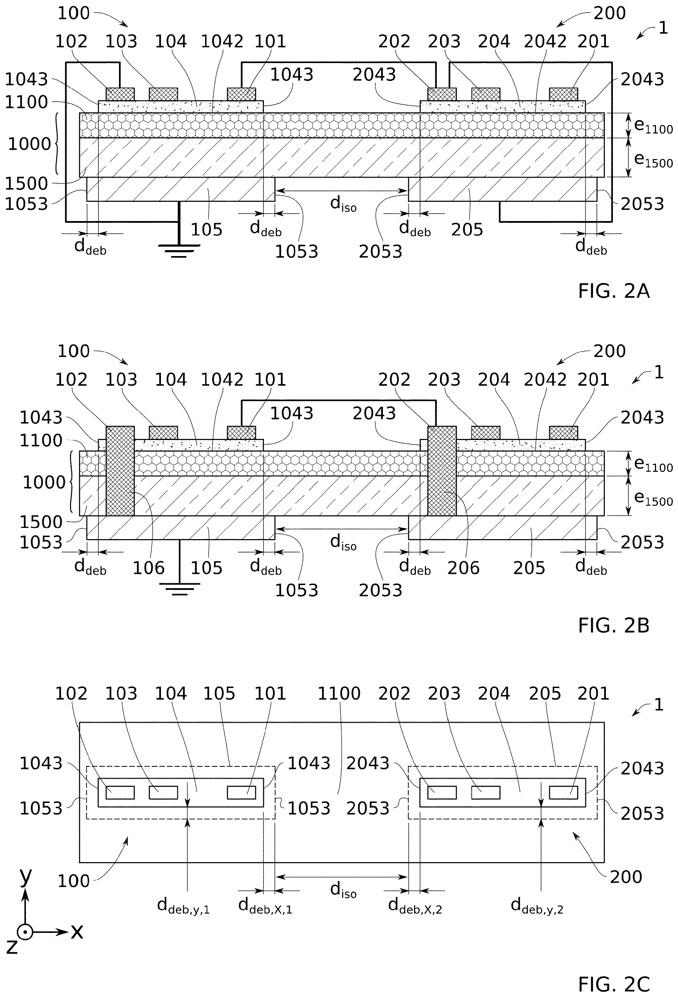

Un repère, de préférence orthonormé, comprenant les axes X, Y, Z est représenté en figure 2A. Ce repère est applicable par extension aux autres figures.

Dans la présente demande de brevet, on parlera préférentiellement d'épaisseur pour une couche et de hauteur pour une structure ou un dispositif. La hauteur est prise perpendiculairement au plan transversal XY. L'épaisseur est prise selon une direction normale au plan d'extension principal de la couche. Ainsi, une couche présente typiquement une épaisseur selon Z, lorsqu'elle s'étend principalement le long du plan transversal XY, et un élément en saillie, par exemple une tranchée d'isolation, présente une hauteur selon Z. Les termes relatifs « sur », « sous », « sous-jacent » se réfèrent préférentiellement à des positions prises selon la direction Z.

Les termes « sensiblement », « environ », « de l'ordre de » signifient « à 10% près, de préférence à 5% près ».

Le dispositif selon différents modes de réalisation de l'invention va maintenant être décrit en référence aux figures 2A à 2C.

Le dispositif 1 comprend au moins deux transistors à effet de champ 100, 200.

Le premier transistor 100 comprend une première couche active 104. Cette première couche active 104 est surmontée d'un premier drain 101, d'une première source 102 et d'une première grille 103 du premier transistor 100. Le premier transistor 100 comprend en outre une première électrode arrière 105 sous-jacente à la première couche active 104. De la même façon, le deuxième transistor 200 comprend une deuxième couche active 204 surmontée d'un deuxième drain 201, d'une deuxième source 202 et d'une deuxième grille 203. Il comprend également une deuxième électrode arrière 205 sous-jacente à la deuxième couche active 204.

Les première et deuxième électrodes arrière 105, 205 permettent notamment un contrôle électrostatique du dispositif 1. Elles peuvent être assimilées respectivement à une première grille arrière et une deuxième grille arrière du dispositif 1.

Les couches actives 104, 204 sont typiquement à base d'un matériau semiconducteur, par exemple un matériau III-V, de préférence un matériau III-N, par exemple du GaN ou un matériau du type $Al_{1-x}Ga_xN$ (avec x variant de 0 à 1).

Afin de limiter les phénomènes de « current collapse », la source 102, 202 et l'électrode arrière 105, 205 de chaque transistor 100, 200 sont reliées électriquement. Par ailleurs, le premier drain 101 du premier transistor 100 est typiquement relié électriquement à la deuxième source 202 du deuxième transistor 200. Le premier transistor 100 et le deuxième transistor 200 forment alors un composant dit bras de pont. Dans cette configuration, le premier transistor 100 est couramment nommé « transistor côté bas », ou, plus fréquemment, désigné par le terme anglais de « low-side transistor ». De la même façon, le deuxième transistor 200 peut être désigné « transistor côté haut » ou « high-side transistor ».

Deux éléments sont dits « reliés électriquement » lorsqu'ils sont chacun en contact avec un même élément de connexion électrique continu présentant une conduction électrique de préférence supérieure à $10^7$ S/m.

**5**

Le dispositif 1 comprend par ailleurs un empilement 100 s'étendant, selon la troisième direction Z :

- D'une part entre la première couche active 104 et la première électrode arrière 105 du premier transistor 100, et
- D'autre part entre la deuxième couche active 204 et la deuxième électrode arrière 205 du deuxième transistor 200.

L'empilement 1000 présente une épaisseur $e_{1000}$ selon la troisième direction Z.

L'empilement 1000 est typiquement continu, notamment dans le plan transversal XY, entre les deux transistors 100, 200.

L'empilement 1000 comprend une pluralité de couches empilées selon la troisième direction Z. Il comprend notamment une couche isolante 1500 à base d'un premier diélectrique. La couche isolante 1500 est d'un seul tenant, c'est-à-dire continue, entre les deux transistors 100, 200 dans le plan transversal XY.

Le premier diélectrique peut par exemple être un oxyde ($SiO_2$, $Al_2O_3$, $HfO_2$...).

La première couche isolante 1500 présente selon la troisième direction Z une épaisseur $e_{1500}$. Elle présente également selon cette même direction une tension de claquage $V_c$ et un champ critique $E_c$.

La première couche isolante 1500 doit être suffisamment épaisse pour permettre une bonne tenue en tension verticale du dispositif 1. On définit pour ce faire une épaisseur minimum $e_{1500,min}$ de la couche isolante 1500 correspondant à l'épaisseur pour laquelle un court-circuit entre la couche active 104, 204 d'un des transistors 100, 200 et son électrode arrière 105, 205 a lieu, à une tension de claquage cible fixée en fonction des applications visées pour le dispositif 1. La tension de claquage cible se trouve dans les spécifications fournies avec les dispositifs de ce type. Cette épaisseur minimum est définie par la relation suivante : $e_{1500,min}=V_{cible}/E_c$, $V_{cible}$ étant la valeur cible pour la tension de claquage. En pratique, la tension de claquage réelle, $V_c$, de la couche isolante 1500, sera supérieure à la tension de claquage cible $V_{cible}$. La tension de claquage cible $V_{cible}$ de la couche isolante est indiquée dans la fiche de spécification du dispositif.

La couche isolante 1500 est donc dimensionnée de façon à ce que son épaisseur $e_{1500}$ soit supérieure à $e_{1500,min}$. De cette façon, le dispositif 1 peut résister à toute tension inférieure à la tension de claquage cible lui étant appliquée. L'épaisseur $e_{1500,min}$ correspond à la tension de claquage instantanée du dispositif 1. Cependant, afin de garantir une meilleure tenue dans le temps, notamment une tenue dans le temps compatible avec la durée de vie typique des applications envisagées pour le dispositif 1, on opte pour une épaisseur $e_{1500}$ supérieure à $2*e_{1500,min}$. Cela permet d'obtenir que le dispositif 1 présente une durée de vie du dispositif 1 typiquement supérieure à 10 ans pour la tension de claquage cible.

Compte tenu de ce qui est dit précédemment, l'épaisseur $e_{1500}$ de la couche isolante 1500 est inférieure à $10*e_{1500,min}$. En limitant ainsi l'épaisseur de la couche isolante 1500, une bonne polarisation verticale du dispositif 1 est garantie. Il est en effet nécessaire que le potentiel du substrat ait un contrôle effectif sur la polarisation des couches actives du dispositif 1 et ainsi limiter les effets de current collapse.

Une épaisseur $e_{1500}$ comprise entre $2*e_{1500,min}$ et $10*e_{1500,min}$ apparaît comme le meilleur compromis entre un diélectrique suffisamment épais pour garantir la durée de vie et suffisamment fin pour maximiser la polarisation en face arrière du composant. Pour les mêmes raisons, la plage comprise entre $2*e_{1500,min}$ et $5*e_{1500,min}$ est particulièrement avantageuse. $e_{1500}$ peut également être supérieure à $5*e_{1500,min}$, ce qui permet de maximiser encore le durée de vie ou de minimiser les risques de claquage prématuré.

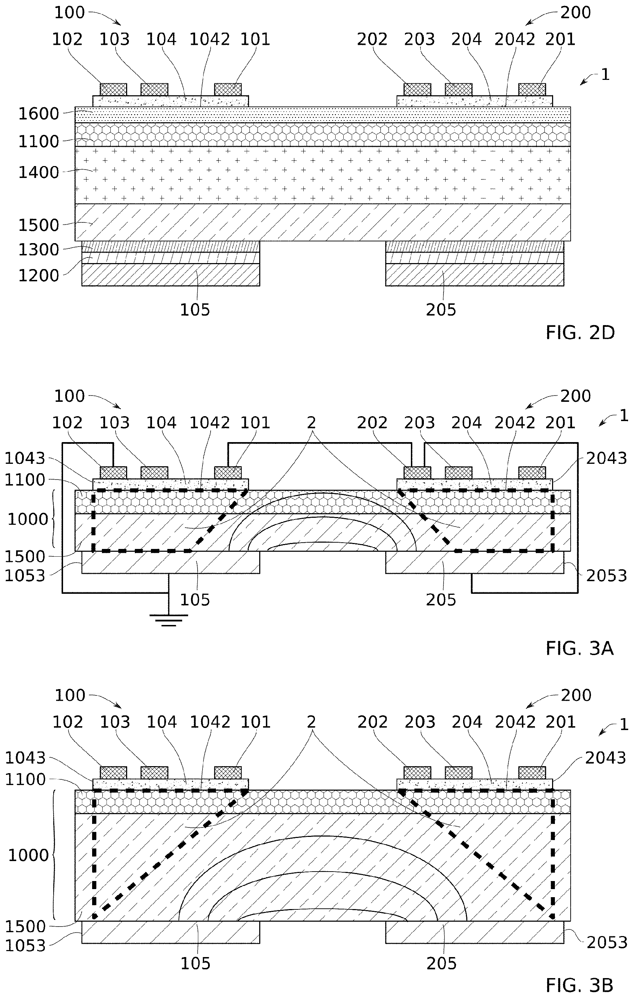

Les figures 3A et 3B illustrent respectivement un cas dans lequel la polarisation verticale du dispositif 1 est assurée et un cas dans lequel le couplage latéral prend le dessus sur la polarisation verticale. Sur ces deux figures, les zones hachurées 2 représentent les zones d'influence électrostatique de l'électrode arrière sur les couches actives 104, 204 des deux transistors 100, 200, et de façon générale sur le dispositif 1. Les lignes, reliant notamment la première électrode arrière 105 et la deuxième électrode arrière 205, sont les lignes de champ : elles illustrent la tenue en tension latérale - ou couplage latéral - entre les deux transistors 100, 200. Un bon équilibre entre polarisation verticale et tenue en tension latérale doit être trouvé. On observe sur la figure 3A que l'influence des électrodes arrière 105, 205 sur les zones actives est optimale. Le couplage latéral n'interfère que très peu sur la polarisation verticale. L'intégrité électrostatique du dispositif 1 est donc préservée. A l'inverse, sur la figure 3B, les électrodes arrière 105, 205 n'ont presque plus d'influence électrostatique sur le dispositif. L'épaisseur de la couche isolante 1500 est trop épaisse pour garantir la polarisation verticale. Le couplage latéral est trop important pour garantir un bon fonctionnement du dispositif 1. L'intégrité électrostatique du dispositif 1 n'est dans ce cas pas préservée.

A titre d'exemple, pour un dispositif 1 devant fonctionner à une tension de 650V, il est courant de chercher à ce que le dispositif 1 présente une tension de claquage supérieure à 900V, par exemple 1000V. La tension de claquage cible est donc dans cet exemple 1000V. La table 1 donne des gammes d'épaisseurs $e_{1500}$ possibles pour différents diélectriques envisageables pour le premier diélectrique :

Tableau

| Premier diélectrique | $E_c$ théorique | $e_{1500,min}$ | Exemple de gamme possible pour $e_{1500,min}$ |
|---|---|---|---|
| $SiO_2$ | 12 MV/cm | 0,8 $\mu m$ | 1-10 $\mu m$ |
| $Al_2O_3$ | 8-10 MV/cm | 1-1,2 $\mu m$ | 1-10 $\mu m$ |
| $Si_3N_4$ | 10-12 MV/cm | 0,8-1 $\mu m$ | 1-10 $\mu m$ |
| $HfO_2$ | 5-6 MV/cm | 1,6-2 $\mu m$ | 2-20 $\mu m$ |

Un critère pour la sélection du premier diélectrique peut ainsi être la valeur de son champ électrique critique théorique.

Le premier diélectrique présente de plus une conductivité électrique notée $\sigma_1$. Cette dernière est de préférence inférieure à $10^{-17}\ \Omega^{-1}.m^{-1}$. Le fait que la tenue en tension verticale soit principalement assurée par la couche isolante 1500 permet de réduire le courant de fuite du dispositif 1. Les diélectriques présentent en effet des valeurs de conductivité électrique bien inférieures à celles des matériaux couramment utilisés pour les couches épitaxiées des composants, couches servant habituellement à la tenue en tension verticale. L'invention permet donc de tirer profit des valeurs avantageuses de conduction électrique des diélectriques. De préférence, l'épaisseur $e_{1500}$ et la conductivité électrique $\sigma_1$ de la couche isolante 1500 sont telles que le courant de fuite est inférieur à $1\mu A/cm^2$ à la tension maximale d'application (exemple : 650V). L'invention peut même permettre des niveaux de courant de fuite aussi faibles que $1nA/cm^2$.

Le premier diélectrique présente par ailleurs une conductivité thermique $\lambda_1$ supérieure à $1W.m^{-1}.K^{-1}$, de préférence supérieure à $30W.m^{-1}.K^{-1}$. Un tel niveau de conductivité thermique permet une bonne évacuation de la chaleur contenue dans le dispositif 1.

Les conductivités électrique et thermique du matériau peuvent ainsi constituer d'autres critères de sélection du premier diélectrique.

L'empilement 1000 comprend par ailleurs une troisième couche active 1100, sous-jacente aux première et deuxième couches actives 104, 204. Cette troisième couche active 1100 est de préférence elle aussi continue sous et entre les deux transistors 100, 200. Elle se situe au-dessus de la couche isolante 1500 selon la troisième direction Z. Elle peut par exemple être au contact de la face inférieure 1042 de la première couche active 104 et de la face inférieure 2042 de la deuxième couche active 204.

La troisième couche active 1100 est à base de GaN, de préférence dopé carbone.

La troisième couche active 1100 assure en partie la tenue en tension latérale du dispositif 1. Les épaisseurs typiques de cette couche sont de 1 à 4 $\mu m$, avec un dopage en carbone typiquement compris entre $10^{18}$ et $5.10^{19}$ atomes/cm$^3$.

L'empilement peut également comprendre une ou plusieurs couches d'ajustement des contraintes ou couches buffers 1400. Ces couches peuvent par exemple être à base de Si, SiC ou encore de saphir.

L'empilement 1000 comprend avantageusement une première couche barrière 1200 et une couche d'adhérence 1300 entre la première électrode arrière 105 et la couche isolante 1500 d'une part et la deuxième électrode arrière 205 et la couche isolante 1500 d'autre part. Ces deux couches 1200, 1300 présentent de préférence une discontinuité entre les deux transistors 100, 200 dans le plan transversal XY. La première couche barrière 1200 peut par exemple être à base de TiN ou de TaN. Elle présente selon la troisième direction Z une épaisseur $e_{1200}$ de préférence comprise entre 10nm et 50nm, par exemple sensiblement égale à 40 nm. Dans le cas où la première couche barrière 1200 est à base de TiN, la couche d'adhérence 1300 est typiquement à base de Ti. La couche d'adhérence peut également être à base de Ta. Elle présente selon la troisième direction Z une épaisseur $e_{1300}$ de préférence comprise entre 5 et 20nm, par exemple sensiblement égale à 10 nm.

Selon un mode de réalisation particulier illustré à la figure 2D, l'empilement 1000 comprend, selon la troisième direction Z, les couches suivantes :

- Une première couche barrière 1200, au contact des électrodes arrière 105, 205,
- Une couche d'adhérence 1300,
- Une couche isolante 1500,
- Une ou plusieurs couches d'ajustement des contraintes 1400,
- Une troisième couche active 1100,
- Une deuxième couche barrière 1600, au contact des couches actives 104, 204.

Il est par ailleurs parfaitement envisageable que l'empilement 1000 comprenne plusieurs couches isolantes, par exemple chacune à base d'un matériau différent. Cela peut permettre de tirer profit de propriétés électriques et thermiques de différents matériaux diélectriques.

Afin de garantir l'isolation de chacune des polarisations du substrat, la première électrode arrière 105 et la deuxième électrode arrière 205 sont avantageusement séparées dans le plan transversal XY d'une distance d'isolation latérale $d_{iso}$ étant de préférence supérieure à 50$\mu$m, typiquement supérieure à 100$\mu$m. Dans un souci d'optimisation de la densité des composants, $d_{iso}$ est de préférence inférieure à 300$\mu$m.

Comme illustré à la figure 2C, les électrodes arrière 105, 205 de chacun des transistors sont de préférence, en projection dans le plan transversal XY, en saillie par rapport aux couches actives 104, 204. On définit pour la premier transistor 100 une première distance de débordement $d_{deb,1}$, correspondant à la distance dans le plan transversal XY entre un flanc 1043 de la première couche active 104 et un flanc 1053 de la première électrode arrière 105. Une deuxième distance de débordement $d_{deb,2}$, correspondant à la distance dans le plan transversal XY entre un flanc 2043 de la deuxième couche active 204 et un flanc 2053 de la deuxième électrode arrière 205, est définie pour le deuxième transistor 200.

Les distances de débordement $d_{deb,1}$, $d_{deb,2}$, peuvent être définies dans n'importe quelle direction du plan transversal XY. Par exemple, il peut être défini que, comme illustré à la figure 2C :

- selon la première direction X :

    i. la première électrode arrière 105 est en saillie par rapport à la première couche active 104 sur une première distance de débordement selon la première direction $d_{deb,X,1}$,
    ii. la deuxième électrode arrière 205 est en saillie par rapport à la deuxième couche active 204 sur une deuxième distance de débordement selon la première direction $d_{deb,X,2}$,

- selon la deuxième direction Y :

    i. la première électrode arrière 105 est en saillie par rapport à la première couche active 104 sur une première distance de débordement selon la deuxième direction $d_{deb,Y,1}$,
    ii. la deuxième électrode arrière 205 est en saillie par rapport à la deuxième couche active 204 sur une deuxième distance de débordement selon la deuxième direction $d_{deb,Y,2}$.

Quelle que soit la direction selon laquelle elles sont définies, les distances de débordement $d_{deb,1}$, $d_{deb,2}$ sont de préférence non nulles (c'est-à-dire, par exemple, que $d_{deb,X,1}$, $d_{deb,X,2}$, $d_{deb,Y,1}$, $d_{deb,Y,2}$ >0). Cela permet de minimiser le champ électrique entre chaque source 102, 202 et la face arrière du dispositif 1. L'intégrité électrostatique des transistors 100, 200 et plus généralement du dispositif 1 est ainsi améliorée.

Avantageusement, les distances de débordement $d_{deb,1}$, $d_{deb,2}$ sont chacune supérieure à la somme de l'épaisseur $e_{1500}$ de la couche isolante et de l'épaisseur $e_{1100}$ de la troisième couche active 1100. De façon préférentielle, elles sont chacune supérieure à l'épaisseur $e_{1000}$ de l'empilement 1000 dans son intégralité. Prévoir de telles distances de débordement $d_{deb,1}$, $d_{deb,2}$ permet d'empêcher le champ électrique d'un dispositif voisin d'influencer le potentiel entre la source et la face arrière du dispositif 1. Cela confère ainsi au dispositif 1 une intégrité électrostatique optimale.

Selon un mode de réalisation avantageux de l'invention, la source 102, 202 de chaque transistor 100, 200 est relié électriquement à l'électrode arrière 105, 205 du même transistor par l'intermédiaire d'un élément de connexion électrique 106, 206 enterré dans le dispositif 1. Les éléments de connexion électrique 106, 206 s'étendent principalement selon la troisième direction Z et traversent l'empilement 1000.

Ces éléments de connexion électrique 106, 206 peuvent être formés par une gravure profonde de l'empilement 1000. En fonction du mode de réalisation du dispositif 1, ces gravures peuvent présenter une profondeur selon la troisième direction Z allant de quelques dizaines de nanomètres à quelques microns, typiquement entre 4 et 6 $\mu$m. Les éléments de connexion électrique 106, 206 sont ensuite formés par le dépôt d'un métal dans les cavités formées lors de la gravure.

Le dispositif 1 selon l'invention est particulièrement propice à l'intégration d'éléments de connexion électrique de ce type. En effet, l'invention permet de polariser efficacement et de façon indépendante des composants intégrés au sein d'un même substrat, notamment en reliant le substrat d'un composant à sa source. Il est judicieux de réaliser cette connexion électrique au sein du dispositif, au travers de l'empilement 1000, et non via une connexion externe par le boitier. Cela permet notamment une meilleure compacité du dispositif 1.

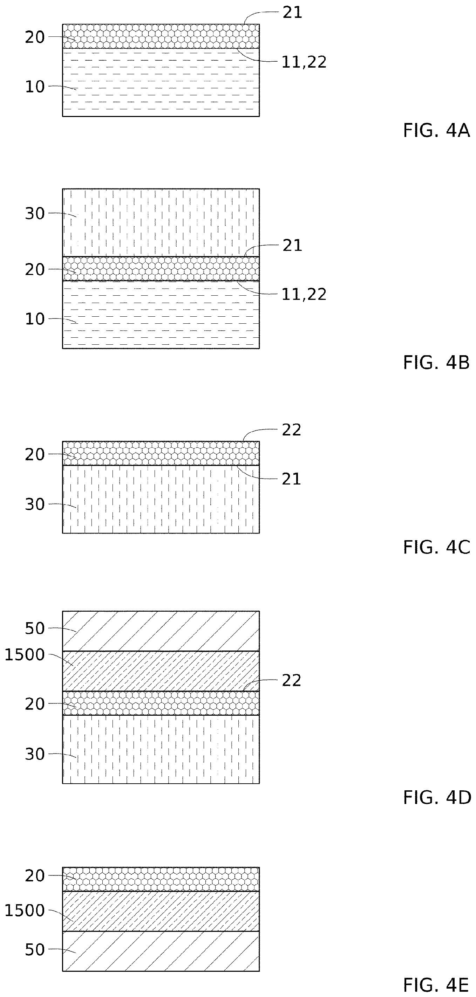

Un exemple de procédé de réalisation d'un dispositif 1 selon l'invention va maintenant être décrit en référence aux figures 4A à 4E. Cet exemple retrace des étapes principales d'un procédé de fabrication du dispositif 1. Il est important de noter que de nombreuses étapes intermédiaires peuvent être mises en œuvre en sus des étapes illustrées aux figures4A à 4E. Cet exemple vise principalement à illustrer des étapes clés pouvant être mises en œuvre et déclinées dans de nombreux modes de réalisation du procédé selon l'invention.

Une première étape consiste à fournir un substrat 10 présentant une face supérieure 11. La figure 4A illustre ensuite une étape de formation d'une couche active 20 sur la face supérieure 11 du substrat 10. La couche active 20 présente une face inférieure 22 en contact avec la face supérieure du substrat et une face supérieure 21. La couche active 20 est ensuite transformée de sorte à former les composants souhaités. La couche active 20 peut notamment comprendre en autres les première couche active 104, deuxième couche active 204, et troisième couche active 1100 et présenter leurs caractéristiques et effets techniques.

Comme représenté à la figure 4B, une poignée 30 est ensuite fixée à la face supérieure 21 de la couche active 20. L'ensemble est ensuite retourné et le substrat 10 est retiré, comme illustré à la figure 4C.

Une couche isolante 1500 est ensuite déposée sur la face inférieure 22 de la couche active 20, puis une couche conductrice 50 est déposée sur la couche isolante 1500, conduisant ainsi à l'empilement illustré en figure 4D. Comme illustré en figure 4E, la poignée 30 est ensuite retirée. On obtient ainsi un empilement composé de la couche conductrice 50, de la couche isolante 1500 et de la couche active 20. La couche conductrice 50 peut ensuite être singularisée en électrodes, i.e. en grilles arrière de transistors.

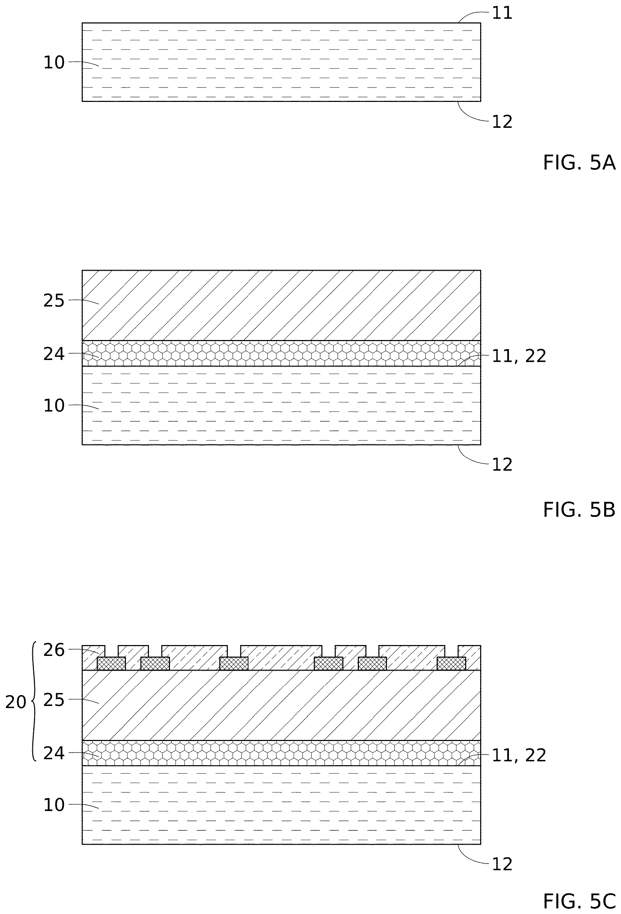

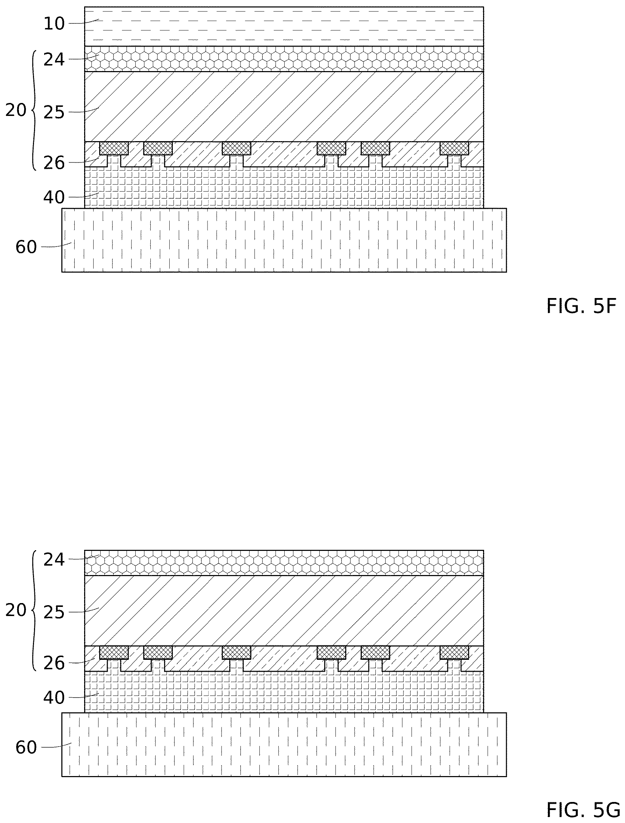

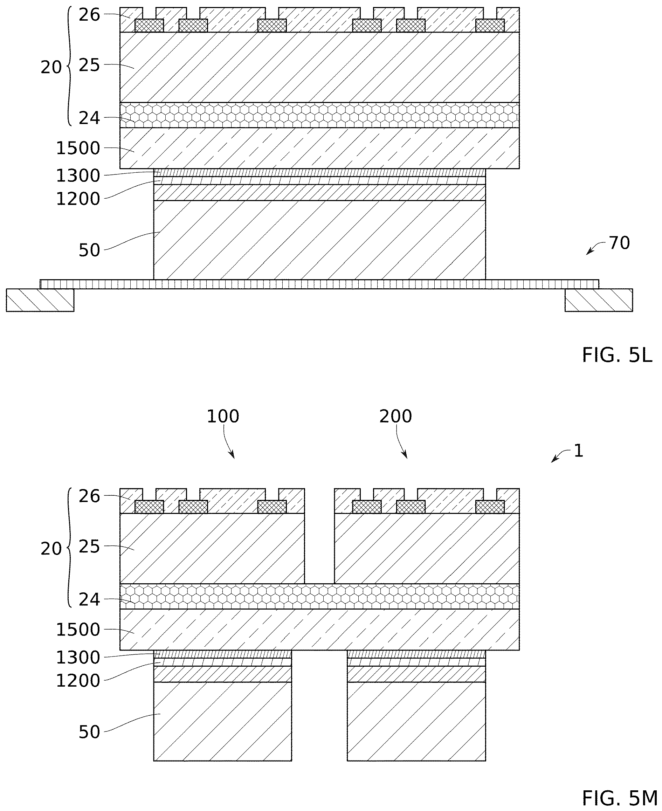

Un autre exemple de procédé de réalisation d'un dispositif 1 selon l'invention va maintenant être décrit en référence aux figures 5A à 5M.

La figure 5A illustre la fourniture d'un substrat 10 présentant une face supérieure 11 et une face inférieure 12.

Comme illustré en figure 5B, une épitaxie est ensuite réalisée à partir de la face supérieure 11 du substrat 10. Lors de cette épitaxie, peuvent notamment être formés : une couche de nucléation, une ou des couches d'ajustement des contraintes 1400, une ou plusieurs couches actives 24, 25, 26 (dont par exemple une couche à base de GaN dopé carbone), une couche barrière et une couche passivation.

Parallèlement et suite à cette étape, différents éléments du dispositif 1 (par exemple les canaux, les contacts ohmiques...) sont formés. Notamment, les niveaux FEOL (Front End Of Line) et BEOL (Back End Of Line) du dispositif 1 peuvent être réalisés à ce stade du procédé.

Les éléments de connexion électrique 106, 206 traversant l'empilement 1000 peuvent également être formés à cette occasion. Une gravure sélective des matériaux de l'empilement 1000 avec un arrêt au niveau du substrat sous-jacent peut notamment permettre de former des cavités dans lesquelles est ensuite déposé un métal constituant les éléments de connexion électrique 106, 206.

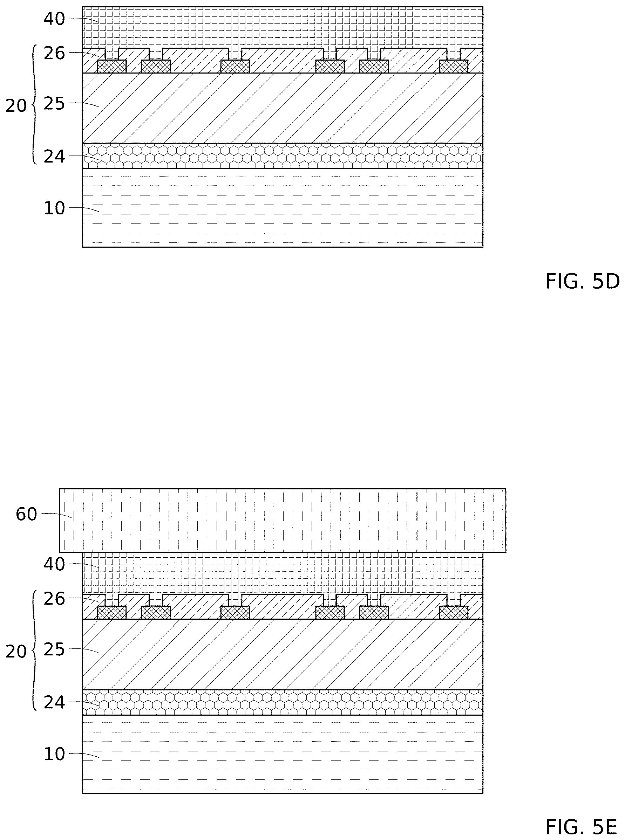

Une couche de colle 40 peut ensuite être déposée sur (figure 5D).

L'ensemble est ensuite transféré sur un deuxième substrat 60 dit poignée (figure 5E). Comme illustré par les figures 5E à 5G, l'ensemble est retourné et le substrat 10 entièrement retiré.

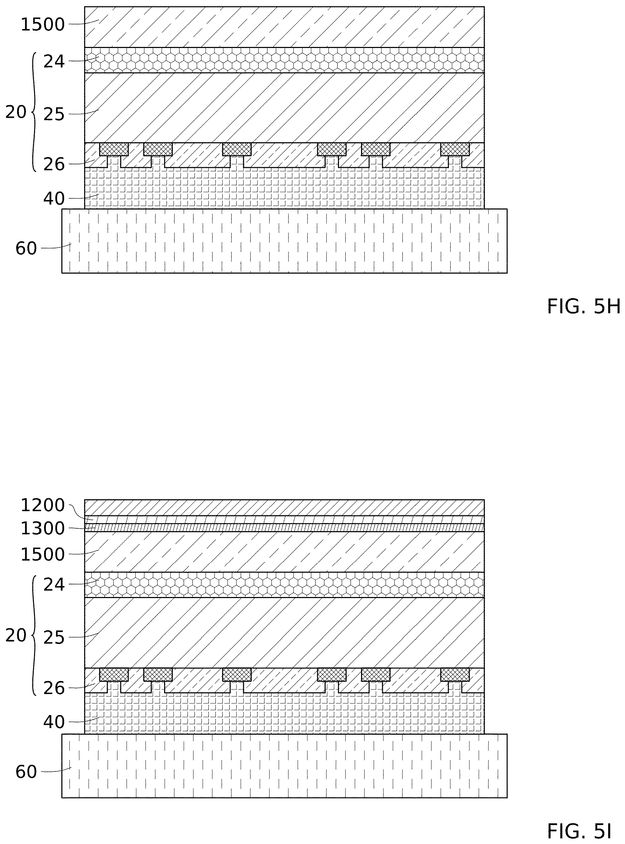

Une couche isolante 1500 peut ensuite être déposée sur une face arrière 32 de la couche active 20 (figure 5H).

Avantageusement, ce dépôt est réalisé à basse température. Cela permet de conserver une bonne adhérence de l'ensemble avec la poignée. Cela permet également d'éviter de dégrader les éléments formés lors de procédés BEOL précédemment mis en œuvre.

Le dépôt de la couche isolante 1500 est typiquement réalisé par dépôt de couche atomique ALD (acronyme anglais de « Atomic Layer Deposition »). Il peut par exemple s'agir d'un dépôt ALD de $Al_2O_3$ effectué à moins de 400°C, par exemple environ 300°C. Ce dépôt peut également être réalisé par dépôt chimique en phase vapeur assisté par plasma, connu sous le terme anglais de « Plasma-enhanced chemical vapor deposition » (PECVD). Il peut notamment s'agir d'un dépôt PECVD de SiO2 ou de SiN. La couche isolante 1500 peut également être déposée par dépôt chimique en phase vapeur CVD (acronyme de « Chemical Vapor Deposition »). Cette technique est notamment avantageuse dans le cas d'un dépôt de diamant.

D'autres couches peuvent ensuite être déposées sur la couche isolante 1500 (couche d'adhérence 1300, couche barrière 1200...), comme représenté à la figure 5I.

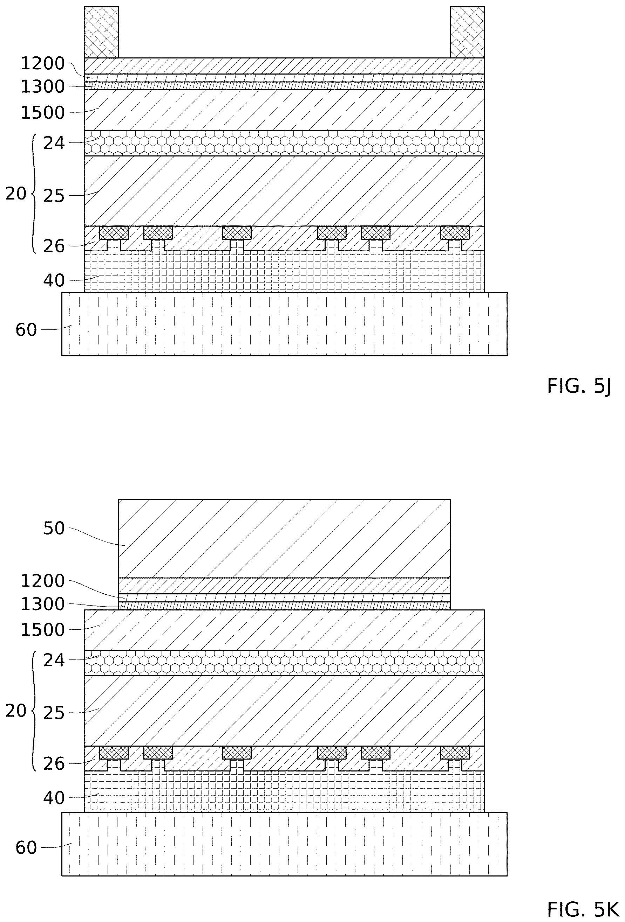

Les figures 5J et 5K illustrent la formation d'une couche conductrice 50 correspondant par exemple aux électrodes arrière 105, 205 du dispositif 1. La couche conductrice 50 est de préférence déposée par voie électrochimique. Elles sont avantageusement à base de cuivre.

Comme illustré en figure 5L, l'ensemble peut ensuite être à nouveau retourné et déposé, au niveau de la face arrière 52 de la couche conductrice 50, sur un cadre support 70.

Le procédé peut être terminé par des étapes de retrait de la poignée, de singularisation des électrodes arrière à partir de la couche conductrice 50, de singularisation de la couche active 20, de singularisation des dispositifs 1 et de mise en boitier.

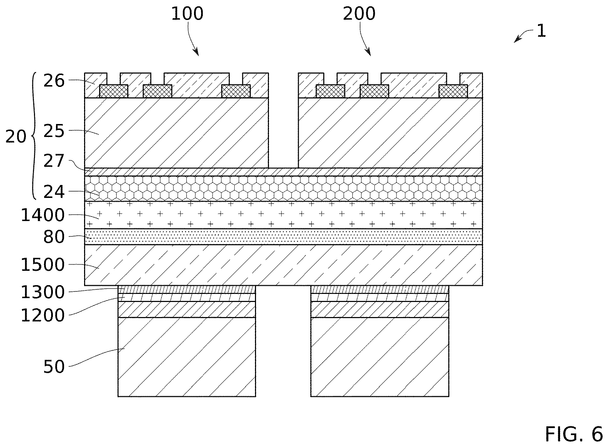

La figure 6 illustre un dispositif pouvant être obtenu par un procédé similaire, dans lequel la couche active 20 comprend, en plus des couches actives 24, 25, 26, une couche barrière pouvant par exemple être à base d'AlGaN, et comprenant en outre une couche d'ajustement des contraintes 1400 et une couche de transition 80, de préférence à base d'AlN, s'étendant entre la couche isolante 1500 et la couche active 20.

A travers les différents modes de réalisation décrits ci-dessus, il apparaît clairement que l'invention propose un dispositif intégrant plusieurs composants unitaires répondant aux besoins de l'industrie, à savoir présentant à la fois une bonne tenue en tension et une bonne évacuation thermique.

Le dispositif selon l'invention présente par ailleurs de nombreux autres avantages relativement aux dispositifs existants.

Pour réaliser le dispositif 1, contrairement aux procédés permettant d'obtenir les dispositifs existants, il n'est pas nécessaire de réaliser l'épitaxie d'une couche active épaisse (typiquement une couche épaisse de GaN). La tenue en tension verticale est en effet garantie par la couche isolante 1500 et non pas par la troisième couche active 1100. L'épitaxie des couches actives peut donc être réduite au strict nécessaire, ce qui correspond à la réalisation des couches de nucléation, du canal de chacun des transistors, d'une éventuelle couche barrière et d'éventuelles couches d'ajustement des contraintes. Les contraintes mécaniques dues à l'épitaxie de ces éléments sont donc fortement réduites. Grâce à cela, il est possible de réaliser des dispositifs selon l'invention, par exemple des composants de puissance, sur des substrats de plus grand diamètre, notamment des substrats silicium.

Par ailleurs, la tenue en tension et le contrôle du niveau de fuite n'étant plus dépendant des couches épitaxiées (typiquement des couches à base de GaN, notamment des couches contenant du GaN fortement dopé carbone), l'invention permet de réduire le risque de dérive du composant lié aux piégeages dans ces couches.

L'invention peut également s'appliquer aux composants de puissance individuels afin d'améliorer leur tenue en tension et la gestion de l'évacuation thermique.

L'invention présente également des avantages dans le cadre des développement dits « GaN-IC » où l'isolation électrique entre composants de puissance propre et composants d'adressage est bénéfique.

L'invention n'est pas limitée aux modes de réalisations précédemment décrits et s'étend à tous les modes de réalisation couverts par l'invention telle qu'elle est définie par les revendications.

## Revendications

1. Dispositif microélectronique (1) comprenant :

   • un premier transistor (100) à effet de champ comprenant une première couche active (104) ainsi qu'un premier drain (101), une première source (102), une première grille (103) surmontant la première couche active (104),
   • un deuxième transistor (200) à effet de champ comprenant une deuxième couche active (204) ainsi qu'un deuxième drain (201), une deuxième source (202) et une deuxième grille (203) surmontant la deuxième couche active (204), la deuxième source (202) étant reliée électriquement au premier drain (101),
   • une première électrode arrière (105), sous-jacente à la première couche active (104) selon une direction d'empilement (Z) perpendiculaire à un plan transversal (XY) défini par une première direction (X) et une deuxième direction (Y), la première électrode arrière (105) étant reliée électriquement à la première source (102),
   • une deuxième électrode arrière (205), sous-jacente à la deuxième couche active (204) selon la direction d'empilement (Z), la deuxième électrode arrière (205) étant séparée de la première électrode arrière (105), la deuxième électrode arrière (205) étant reliée électriquement à la deuxième source (202),
   • un empilement (1000), où l'empilement (1000) comprend :
   • une troisième couche active (1100) continue et à base de GaN, sous-jacente à la première couche active (104) d'une part et à la deuxième couche active (204) d'autre part, et
   • une couche isolante (1500) s'étendant, selon la direction d'empilement (Z), entre la première électrode arrière (105) et la première couche active (104) d'une part et la deuxième électrode arrière (205) et la deuxième couche active (204) d'autre part, la couche isolante (1500) étant continue et à base d'un premier diélectrique, la couche isolante (1500) présentant selon la direction d'empilement (Z) un champ critique $E_c$, la couche isolante (1500) présentant selon la direction d'empilement (Z) une épaisseur dite épaisseur de diélectrique $e_{1500}$ comprise entre $2*e_{1500,min}$ et $10*e_{1500,min}$, avec $e_{1500,min}=V_{cible}/E_c$, $V_{cible}$ étant une tension de claquage cible de la couche isolante (1500), le premier diélectrique présentant une conductivité thermique $\lambda_1$ supérieure à $1W.m^{-1}.K^{-1}$.

2. Dispositif (1) selon la revendication précédente, dans lequel $V_{cible} \geq 900V$.

3. Dispositif (1) selon l'une quelconque des revendications précédentes dans lequel, dans le plan transversal (XY), la première électrode arrière (105) et la deuxième électrode arrière (205) sont séparées d'une distance d'isolation latérale $d_{iso}$ supérieure à 50 $\mu m$, de préférence supérieure à 100 $\mu m$.

4. Dispositif (1) selon l'une quelconque des revendications précédentes dans lequel, en projection dans le plan transversal (XY) et selon toute direction du plan transversal (XY) :

   • la première électrode arrière (105) est en saillie par rapport à la première couche active (104) sur une première distance de débordement $d_{deb,1}$, avec $d_{deb,1}>0$, et
   • la deuxième électrode arrière (205) est en saillie par rapport à la deuxième couche active (204) sur une deuxième distance de débordement $d_{deb,2}$, avec $d_{deb,2}>0$.

5. Dispositif (1) selon la revendication précédente dans lequel l'empilement (1000) présente une épaisseur $e_{1000}$ selon la direction d'empilement (Z), avec $d_{deb,1} \geq e_{1000}$ et $d_{deb,2} \geq e_{1000}$.

6. Dispositif (1) selon l'une quelconque des revendications précédentes dans lequel le premier diélectrique est l'un parmi l'AlN, le $SiO_2$, l'$Al_2O_3$, le $Si_3N_4$, le $HfO_2$ et le diamant.

7. Dispositif (1) selon l'une quelconque des revendications précédentes comprenant en outre un premier élément de connexion électrique (106) traversant l'empilement (1000) et connectant électriquement la première source (102) à la première électrode arrière (105).

8. Dispositif (1) selon l'une quelconque des revendications précédentes comprenant en outre un deuxième élément de connexion électrique (206) traversant l'empilement (1000) et connectant électriquement la deuxième source (202) à la deuxième électrode arrière (205).

9. Dispositif (1) selon l'une quelconque des revendications précédentes dans lequel $e_{1500} \geq 1\mu m$, de préférence $e_{1500} \geq 2\mu m$.

10. Dispositif (1) selon l'une quelconque des revendications précédentes dans lequel la troisième couche active (1100) est directement au contact de la première couche active (104) et de la deuxième couche active (204).


**Patentansprüche**

1. Mikroelektronische Vorrichtung (1), umfassend:

   • einen ersten Feldeffekttransistor (100), der eine erste aktive Schicht (104) sowie einen ersten Drain (101), eine erste Source (102), ein erstes Gate (103), das über der ersten aktiven Schicht (104) liegt, umfasst,
   • einen zweiten Feldeffekttransistor (200), der eine zweite aktive Schicht (204) sowie einen zweiten Drain (201), eine zweite Source (202), und ein zweites Gate (203), das über der zweiten aktiven Schicht (204) liegt umfasst, wobei die zweite Source (202) elektrisch mit dem ersten Drain (101) verbunden ist,
   • eine erste Rückelektrode (105), die unter der ersten aktiven Schicht (104) gemäß einer Stapelungsrichtung (Z) senkrecht zu einer Querebene (XY), die durch eine erste Richtung (X) und eine zweite Richtung (Y) definiert ist, liegt, wobei die erste Rückelektrode (105) elektrisch mit der ersten Source (102) verbunden ist,
   • eine zweite Rückelektrode (205), die unter der zweiten aktiven Schicht (204) gemäß der Stapelungsrichtung (Z) liegt, wobei die zweite Rückelektrode (205) von der ersten Rückelektrode (105) getrennt ist, wobei die zweite Rückelektrode (205) elektrisch mit der zweiten Source (202) verbunden ist,
   • eine Stapelung (1000),

   wobei die Stapelung (1000) Folgendes umfasst:

   • eine durchgehende dritte aktive Schicht (1100) auf GaN-Basis, die unter der ersten aktiven Schicht (104) einerseits und der zweiten aktiven Schicht (204) andererseits liegt, und
   • eine Isolierschicht (1500), die sich gemäß der Stapelungsrichtung (Z) zwischen der ersten Rückelektrode (105) und der zweiten aktiven Schicht (104) einerseits und der zweiten Rückelektrode (205) und der zweiten aktiven Schicht (204) andererseits erstreckt, wobei die Isolierschicht (1500) durchgehend und auf Basis eines ersten Dielektrikum ist, wobei die Isolierschicht (1500) gemäß der Stapelungsrichtung (Z) ein kritisches Feld Ec aufweist, die Isolierschicht (1500) gemäß der Stapelungsrichtung (Z) eine als dielektrische Dicke bezeichnete Dicke e1500 aufweist, die zwischen $2*e_{1500,min}$ und $10*e_{1500,min}$ liegt, wobei $e_{1500,min} = V_{Ziel}/Ec$, wobei $V_{Ziel}$ eine Zieldurchschlagspannung der Isolierschicht (1500) ist, wobei das erste Dielektrikum eine Wärmeleitfähigkeit $\lambda 1$ größer als $1 W.m^{-1}.K^{-1}$ aufweist.

2. Vorrichtung (1) nach dem vorstehenden Anspruch, wobei $V_{Ziel} \geq 900\ V$ ist.

3. Vorrichtung (1) nach einem der vorstehenden Ansprüche, wobei in der Querebene (XY) die erste Rückelektrode (105) und die zweite Rückelektrode (205) um einen seitlichen Isolierabstand $d_{iso}$ größer als 50 $\mu m$, bevorzugt größer als 100 $\mu m$ getrennt sind.

4. Vorrichtung (1) nach einem der vorstehenden Ansprüche, wobei in Projektion in der Querebene (XY) und gemäß jeder Richtung der Querebene (XY):

• die erste Rückelektrode (105) in Bezug auf die erste aktive Schicht (104) auf einer ersten Überstanddistanz $d_{deb,1}$ vorragt, wobei $d_{deb,1} > 0$, und
• die zweite Rückelektrode (205) in Bezug auf die zweite aktive Schicht (204) über eine zweite Überstanddistanz $d_{deb,2}$ vorragt, wobei $d_{deb,2} > 0$.

**5.** Vorrichtung (1) nach dem vorstehenden Anspruch, wobei die Stapelung (1000) eine Dicke $e_{1500}$ gemäß der Stapelungsrichtung (Z) aufweist, wobei $d_{deb,1} \geq e_{1500}$ und $d_{deb,2} \geq e_{1000}$.

**6.** Vorrichtung (1) nach einem der vorstehenden Ansprüche, wobei das erste Dielektrikum eines aus AlN, $SiC_2$, $Al_2O_3$, $Si_3N_4$, $HfO_2$ und Diamant ist.

**7.** Vorrichtung (1) nach einem der vorstehenden Ansprüche, die außerdem ein erstes elektrisches Verbindungselement (106) umfasst, das die Stapelung (1000) durchquert und die erste Source (102) elektrisch mit der ersten Rückelektrode (105) verbindet.

**8.** Vorrichtung (1) nach einem der vorstehenden Ansprüche, die außerdem ein zweites elektrisches Verbindungselement (206) umfasst, das die Stapelung (1000) durchquert und die zweite Source (202) elektrisch mit der zweiten Rückelektrode (205) verbindet.

**9.** Vorrichtung (1) nach einem der vorstehenden Ansprüche, wobei $e_{1500} \geq 1\ \mu m$, bevorzugt $e_{1500} \geq 2\ \mu m$ ist.

**10.** Vorrichtung (1) nach einem der vorstehenden Ansprüche, wobei die dritte aktive Schicht (1100) direkt in Kontakt mit der ersten aktiven Schicht (104) und der zweiten aktiven Schicht (204) steht.

**Claims**

**1.** Microelectronic device (1) comprising:

• a first field effect transistor (100) comprising a first active layer (104) as well as a first drain (101), a first source (102), a first gate (103) surmounting the first active layer (104),
• a second field effect transistor (200) comprising a second active layer (204) as well as a second drain (201), a second source (202) and a second gate (203) surmounting the second active layer (204), the second source (202) being electrically connected to the first drain (101),
• a first rear electrode (105), underlying the first active layer (104) in a stack direction (Z) perpendicular to a transverse plane (XY) defined by a first direction (X) and a second direction (Y), the first rear electrode (105) being electrically connected to the first source (102),
• a second rear electrode (205), underlying the second active layer (204) in the stack direction (Z), the second rear electrode (205) being separated from the first rear electrode (105), the second rear electrode (205) being electrically connected to the second source (202),
• a stack (1000),

where the stack (1000) comprises:

• a continuous and GaN-based third active layer (1100), underlying the first active layer (104), on the one hand, and underlying the second active layer (204), on the other hand, and
• an insulating layer (1500) extending, in the stack direction (Z), between the first rear electrode (105) and the first active layer (104), on the one hand, and the second rear electrode (205) and the second active layer (204), on the other hand, the insulating layer (1500) being continuous and with the basis of a first dielectric, the insulating layer (1500) having, in the stack direction (Z), a critical field $E_c$, the insulating layer (1500) having, in the stack direction (Z), a thickness called dielectric thickness $e_{1500}$ of between $2*e_{1500,min}$ and $10*e_{1500,min}$, with $e_{1500,min} = V_{target}/E_c$, $V_{target}$ being a target breakdown voltage of the insulating layer (1500), the first dielectric having a heat conductivity $\lambda_1$ greater than $1 W.m^{-1}.K^{-1}$.

**2.** Device (1) according to the preceding claim, wherein $V_{target} \geq 900V$.

3. Device (1) according to any one of the preceding claims, wherein, in the transverse plane (XY), the first rear electrode (105) and the second rear electrode (205) are separated by a lateral insulation distance $d_{ins}$ greater than $50\mu m$, preferably greater than $100\mu m$.

4. Device (1) according to any one of the preceding claims, wherein, projecting in the transverse plane (XY) and in any direction of the transverse plane (XY):

   • the first rear electrode (105) projects with respect to the first active layer (104) over a first overflow distance $d_{over,1}$, with $d_{over,1}>0$, and
   • the second rear electrode (205) projects with respect to the second active layer (204) over a second overflow distance $d_{over,2}$, with $d_{over,2}>0$.

5. Device (1) according to the preceding claim, wherein the stack (1000) has a thickness $e_{1000}$ in the stack direction (Z), with $d_{over,1}\geq e_{1000}$ and $d_{over,2}\geq e_{1000}$.

6. Device (1) according to any one of the preceding claims, wherein the first dielectric is one from among AIN, $SiO_2$, $Al_2O_3$, $Si_3N_4$, $HfO_2$ and diamond.

7. Device (1) according to any one of the preceding claims, further comprising a first electrical connection element (106) passing through the stack (1000) and electrically connecting the first source (102) to the first rear electrode (105).

8. Device (1) according to any one of the preceding claims, further comprising a second electrical connection element (206) passing through the stack (1000) and electrically connecting the second source (202) to the second rear electrode (205).

9. Device (1) according to any one of the preceding claims, wherein $e_{1500}\geq 1\mu m$, preferably $e_{1500}\geq 2\mu m$.

10. Device (1) according to any one of the preceding claims, wherein the third active layer (1100) is directly in contact with the first active layer (104) and with the second active layer (204).

100'    200'

102'    103'    101'    202'    203'    201'

FIG. 1

FIG. 2A

FIG. 2B

FIG. 2C

FIG. 2D

FIG. 3A

FIG. 3B

FIG. 4A

FIG. 4B

FIG. 4C

FIG. 4D

FIG. 4E

FIG. 5A

FIG. 5B

FIG. 5C

FIG. 5D

FIG. 5E

FIG. 5F

FIG. 5G

FIG. 5H

FIG. 5I

1200
1300
1500
24
20 { 25
26
40
60

FIG. 5J

50
1200
1300
1500
24
20 { 25
26
40
60

FIG. 5K

26

20 { 25

24

1500

1300

1200

50

70

FIG. 5L

100

200

1

26

20 { 25

24

1500

1300

1200

50

FIG. 5M

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013146946 A1

**Littérature non-brevet citée dans la description**

- **Q. XIE** ; **C. LEE** ; **J. XU** ; **C. WANN** ; **J. Y. -. SUN** ; **Y. TAUR**. Comprehensive Analysis of Short-Channel Effects in Ultrathin SOI MOSFETs. *IEEE Transactions on Electron Devices*, June 2013, vol. 60 (6), 1814-1819

- **JIN WEI** ; **MENG ZHANG** ; **GANG LYU** ; **KEVIN CHEN**. *GaN Integrated Bridge Circuits on Bulk Silicon Substrate: Issues and Proposed Solution*